# EUROPÄISCHE PATENTANMELDUNG

(11) **EP 4 093 165 A1**
(43) Veröffentlichungstag der Anmeldung: **23.11.2022**
(21) Anmeldenummer: 21175091.4
(22) Anmeldetag: 20.05.2021
(51) Int. Cl.: H05K 3/46, H05K 3/28

(54) **GEDRUCKTE ISOLIERSCHUTZSCHICHT**

(71) Anmelder: Würth Elektronik GmbH & Co. KG, 74676 Niedernhall (DE)
(72) Erfinder: Staudt, Alexander, 74906 Bad Rappenau (DE)
(74) Vertreter: Richardt Patentanwälte PartG mbB

(57) **Zusammenfassung**

Die Erfindung ein Verfahren zum Herstellen einer starr-flexiblen Leiterplatte (200), welche ein oder mehrere starre Abschnitte (202) sowie mindestens einen flexiblen Abschnitt (204) umfasst. Der mindestens eine flexible Abschnitt (204) grenzt an mindestens einen der starren Abschnitte (202) an. Das Verfahren umfasst:
• Bereitstellen einer mit ein oder mehreren Leiterbahnen (208) versehenen Zwischenschicht (206),
• Aufdrucken einer Isolierschutzschicht (210) mittels Inkjetdruckverfahren auf die Zwischenschicht (206) innerhalb eines räumlich begrenzten Segments (224), dessen Fläche kleiner als eine Fläche der Zwischenschicht (206) ist, wobei die aufgedruckte Isolierschutzschicht (210) die Leiterbahnen (208) zumindest innerhalb des mindestens einen flexiblen Abschnitts (204) überdeckt,
• Polymerisieren der aufgedruckte Isolierschutzschicht (210),
• Kombinieren der Zwischenschicht (206) mit ein oder mehreren Materialschichten,
• Erzeugen eines Verbundkörpers durch Heißverpressen der Kombination aus Zwischenschicht (206) und ein oder mehreren weiteren Materialschichten,
• Freilegen der Isolierschutzschicht (210) innerhalb des mindestens einen flexiblen Abschnitts (204).

## Beschreibung

Die Erfindung betrifft ein Verfahren zum Herstellen einer starr-flexiblen Leiterplatte, eine Vorrichtung zum Herstellen einer starr-flexiblen Leiterplatte sowie eine entsprechende starr-flexiblen Leiterplatte.

Starr-flexible Leiterplatten finden in vielfältigen Bereichen Anwendung. Derartige starr-flexible Leiterplatten ("rigid flex printed board") aus dem Stand der Technik bekannt und werden beispielsweise in dem Standard IPC-6013 "Qualification and Performance Specification for Flexible/Rigid-Flexible Printed Boards" der IPC beschrieben. Ihre Flexibilität ermöglicht es, dass diese Leiterplatten beispielsweise bei einem Einbau in ein elektronisches Gerät an die dort gegebenen Platzverhältnisse angepasst werden können. Beispielsweise kann eine solche Leiterplatte gebogen oder zusammengefaltet werden und in diesem gebogenen bzw. gefalteten Zustand eingesetzt werden. Ferner ermöglicht es eine starr-flexible Leiterplatte in eingebautem Zustand aufgrund ein oder mehrere flexibler Abschnitt Relativbewegungen zwischen den starren Abschnitten, welche mit über die flexiblen Abschnitte miteinander verbunden sind, mitzumachen. Eine entsprechende starr-flexible Leiterplatte kann beispielsweise Relativbewegungen von Komponenten eines elektrischen Geräts, mit welchem sie im eingebauten Zustand mechanisch verbunden ist, mitmachen. Beispielsweise können Bewegungen eines mechanischen Gelenks mitgemacht werden. Entsprechende starr-flexible Leiterplatte werden unter Verwendung mehrschichtigen Verbundkörper hergestellt, deren Zusammenfügen im Allgemeinen arbeitsintensiv und zweitauwendig ist.

Der Erfindung liegt die Aufgabe zugrunde, ein verbessertes Verfahren zum Herstellen einer starr-flexiblen Leiterplatte zu schaffen.

Die der Erfindung zugrunde liegende Aufgabe wird mit den Merkmalen des unabhängigen Patentanspruchs gelöst. Ausführungsformen der Erfindung sind in den abhängigen Patentansprüchen angegeben.

Ausführungsformen umfassen ein Verfahren zum Herstellen einer starr-flexiblen Leiterplatte, welche ein oder mehrere starre Abschnitte sowie mindestens einen flexiblen Abschnitt umfasst. Der mindestens eine flexible Abschnitt grenzt an mindestens einen der starren Abschnitte an. Das Verfahren umfasst:
- Bereitstellen einer mit ein oder mehreren Leiterbahnen versehenen Zwischenschicht,
- Aufdrucken einer Isolierschutzschicht mittels Inkjetdruckverfahren auf die Zwischenschicht innerhalb eines räumlich begrenzten Segments, dessen Fläche kleiner als eine Fläche der Zwischenschicht ist, wobei die aufgedruckte Isolierschutzschicht die Leiterbahnen zumindest innerhalb des mindestens einen flexiblen Abschnitts überdeckt,
- Polymerisieren der aufgedruckte Isolierschutzschicht,
- Kombinieren der Zwischenschicht mit ein oder mehreren Materialschichten,
- Erzeugen eines Verbundkörpers durch Heißverpressen der Kombination aus Zwischenschicht und ein oder mehreren weiteren Materialschichten,
- Freilegen der Isolierschutzschicht innerhalb des mindestens einen flexiblen Abschnitts.

Eine entsprechende starr-flexible Leiterplatte umfasst einen mehrschichtigen Verbundkörper. Dieser mehrschichtigen Verbundkörper ist aus einer Mehrzahl von Materialschichten aufgebaut. Damit die starr-flexible Leiterplatte im Bereich des flexiblen Abschnitts flexibel ist, werden in diesem Bereich beispielsweise Materialschichten abgetragen. Dabei verbleibt im Bereich des flexiblen Abschnitts beispielsweise nur eine Zwischenschicht. Diese Zwischenschicht erstreckt sich beispielsweise durch die gesamte starr-flexible Leiterplatte, d.h. auch durch starre Abschnitte der Leiterplatte. Eine starr-flexible Leiterplatte ermöglicht beispielsweise einen Einbau in ein Gehäuse, bei welchem der flexible Abschnitt gebogen, verdreht und/oder gefaltet ist. Somit kann die geometrische Form der Leiterplatte angepasst werden und/oder die Leiterplatte kann Bewegungen mitmachen.
Die Zwischenschicht umfasst ferner beispielsweise ein oder mehrere Leiterbahnen. Die entsprechenden Leiterbahn können beispielsweise ein- oder beidseitig auf der Zwischenschicht angeordnet sein. Beidseitig bedeutet in diesem Kontext, dass die entsprechenden Leiterbahnen auf einer Ober- und Unterseite der Zwischenschicht angeordnet sind. Einseitig bedeutet in diesem Kontext, dass die Leiterbahnen ausschließlich auf der Ober- oder Unterseite der Zwischenschicht angeordnet sind. Durch die Reduktion der Dicke der starr-flexiblen Leiterplatte im Bereich des flexiblen Abschnitts kann die Flexibilität des entsprechenden flexiblen Abschnitts erhöht werden. Allerdings ist die so freigelegte Zwischenschicht mit den Leiterbahnen gegen äußere Einflüsse zu schützen. Beispielsweise handelt es sich bei den Leiterbahnen um Leiterbahnen aus Kupfer, welches sehr reaktiv ist. Um die freigelegte Zwischenschicht im Bereich eines flexiblen Abschnitts vor äußeren Einflüssen zu schützen, beispielsweise mechanischen, elektrischen oder chemischen Einflüssen, ist beispielsweise eine Isolierschutzschicht vorgesehen.

Eine entsprechende Isolierschutzschicht dient in erster Linie dazu, die Zwischenschicht mit den Leiterbahnen im Bereich flexibler Abschnitte der starr-flexiblen Leiterplatte vor äußeren Einflüssen zu schützen. Die entsprechende Isolierschutzschicht erstreckt sich vorteilhafterweise nicht über die gesamte Zwischenschicht, um die Funktionalität der Leiterplatte im Bereich starrer Abschnitte nicht negativ zu beeinflussen.

Ein Drucken der Isolierschutzschicht mittels eines Inkjetdruckverfahrens kann den Vorteil haben, dass die Isolierschutzschicht gezielt nur in Bereichen aufgedruckt werden kann, welche mit der Isolierschutzschicht abzudecken sind. Bei den entsprechenden Bereichen handelt es sich beispielsweise um flexible Abschnitte der starr-flexiblen Leiterplatte, welche im Zuge einer späteren Materialreduktion frei angelegt werden. Ein entsprechendes Inkjetdruckverfahren kann den Vorteil haben, dass die Isolierschutzschicht sehr effizient und präzise aufgetragen werden kann. Beispielsweise kann zum Auftragen der Isolierschutzschicht eine Inkjetdruckvorrichtung verwendet werden, welche eine Mehrzahl von Druckköpfen umfasst. Die entsprechenden Druckköpfe können beispielsweise individuell angesteuert werden und ermöglichen ein paralleles Drucken von Isolierschutzschichten in unterschiedlichen flexiblen Abschnitten. Beispielsweise wird eine Mehrzahl von starr-flexiblen Leiterplatten gleichzeitig hergestellt. Beispielsweise werden die Zwischenschicht sowie die weiteren Materialschichten jeweils in Form von Materialbögen bereitgestellt, miteinander kombiniert und heißverpresst, sodass ein Gesamtverbundkörper entsteht, welcher eine Mehrzahl von starr-flexible Leiterplatten umfasst, welche aus dem Gesamtverbundkörper im Zuge des Herstellungsverfahrens herausgeschnitten werden. In diesem Fall kann ein parallelisiertes Druckverfahren beispielsweise zu einer deutlichen Effizienzsteigerung der Herstellung der starr-flexiblen Leiterplatten beitragen.

Zum Fixieren der Form der aufgedruckten Isolierschutzschicht wird diese nach dem Druck polymerisiert. Beispielsweise erfolgt das Polymerisieren unter Verwendung von Hitze und/oder Bestrahlung mit UV-Licht. Unter einem Polymerisieren, im Englischen auch als Curing (Aushärten) bezeichnet, wird ein Aushärten eines Polymermaterials durch ein Vernetzen von Polymerketten verstanden. Während des Aushärtens reagieren Monomere und/oder Oligomere zu einem dreidimensionalen polymeren Netzwerk. Eine Verwendung von Hitze und/oder eine Bestrahlung mit UV-Licht zum Polymerisieren führt somit zu einem Aushärten der aufgedruckten Isolierschutzschichten, wodurch ein Beibehalten der aufgedruckten geometrischen Form im Zuge des anschließenden Heißverpressens der Materialschichten zu dem Verbundkörper sichergestellt werden kann. Insbesondere kann ein Auseinanderfließen der Isolierschutzschicht zwischen den weiteren Materialschichten im Zuge des Heißverpressens vermieden werden. Anschließend werden die ein oder mehreren Isolierschutzschichten innerhalb der ein oder mehreren flexiblen Abschnitte der starr-flexiblen Leiterplatte freigelegt. Das Freilegen der Isolierschutzschichten kann beispielsweise mittels eines materialabtragenden Verfahrens, etwa Fräsen, erfolgen. Im Ergebnis wird die Materialstärke bzw. Dicke der starr-flexiblen Leiterplatte im Bereich der flexiblen Abschnitte deutlich reduziert, wodurch deren Flexibilität erhöht wird bzw. erst ermöglicht wird. Innerhalb dieser Bereiche schützt die aufgedruckte Isolierschutzschicht die Leiterbahnen der Zwischenschicht vor äußeren Einflüssen.

Die Polymerisation erfolgt beispielsweise bei Normaldruck, d.h. 1,01325 bar. Beispielsweise erfolgt das Polymerisieren unter Verwendung von Hitze, etwa bei 140°C bis 170°C, bei 145°C bis 160°C und/oder bei 150°C. Hierzu kann beispielsweise ein Trocknungsofen verwendet werden, insbesondere ein Tunneltrocknungsofen oder ein Heißlufttrocknungsofen. Zum Polymerisieren wird die aufgedruckten Isolierschutzschicht der Hitze ein oder mehrmals ausgesetzt. Beispielsweise wird die aufgedruckten Isolierschutzschicht der Hitze für 30 min bis 120 min, für 50 min bis 100 min, für 60 min bis 90 min ausgesetzt. Beispielsweise wird die aufgedruckten Isolierschutzschicht der Hitze für 60 min ausgesetzt. Beispielsweise wird die aufgedruckten Isolierschutzschicht der Hitze für 90 min ausgesetzt. Beispielsweise erfolgt eine Polymerisation unter Bestrahlung mit UV-Licht, wobei mit dem UV-Licht beispielsweise 1 bis 2 J/cm² eingebracht werden. Als Quelle des UV-Lichts kann beispielsweise eine Halogenmetalldampflampe oder eine Hochdruck-Quecksilberdampflampe verwendet werden. Das UV-Licht umfasst beispielsweise UV-Strahlung im Bereich UV-A (320-390 nm), UV-B (280-320 nm), UVA2 (395-417 nm) und/oder UVV (395-450 nm).

Bei einem Inkjetdruckverfahren bzw. Jetdruckverfahren wird eine flüssige Lösung, welche häufig als Tinte bezeichnet wird, tröpfchenweise digital gesteuert auf eine Oberfläche aufgebracht. Die aufzudruckende Lösung wird in einem Behältnis bereitgestellt, welches mit fluidisch verbunden ist. Mit einem Steuerungsgerät zur Ansteuerung des Druckkopfes wird ein tröpfchenweises Aufbringen der Lösung auf die Oberfläche, beispielsweise die Zwischenschicht, gesteuert. Der Druckkopf ist beispielsweise als Matrix-Druckkopf ausgebildet, bei dem durch den gezielten Abschuss oder das Ablenken kleiner Flüssigkeitströpfchen ein Auftragsmuster bzw. Druckbild erzeugt wird. Der Druckkopf kann z.B. als Drop On Demand Druckkopf ausgebildet sein, d.h. als ein einzelner Tropfen verschießender Druckkopf. Ebenso kann der Druckkopf beispielsweise dazu konfiguriert sein, mehrere Tropfen zu verschießen. Beispielsweise kann eine Druckeinheit bereitgestellt werden, welche mittels des digitalen Druckkopfes die Lösung tröpfchenweise auf die Oberfläche der Zwischenschicht innerhalb der räumlich begrenzten Segmente aufdruckt. Das Aufbringen der Lösung, d.h. Abgabeposition, Abgabemenge, Tröpfchengröße, Tröpfchenanzahl und/oder Abgabefreqeunz, wird dabei von einem Steuerungsgerät gesteuert. Zur Steuerung verwendet das entsprechende Steuerungsgerät beispielsweise Steuerungsdaten. Die entsprechenden Steuerungsdaten können beispielsweise aus einem für das Aufbringen der Lösung vorgesehenen Verteilungsschema resultieren. Mit anderen Worten können die Steuerungsdaten das entsprechende Verteilungsschema in Steuerungsbefehle übersetzen, mit welchen das Steuerungsgerät die Druckeinheit steuert. Bei dem Steuerungsgerät kann es sich um ein in die Druckeinheit integriertes Gerät handeln oder beispielsweise um ein Computersystem, an welches die Druckeinheit angeschlossen ist.

Nach Ausführungsformen umfasst der Druckkopf ein oder mehrere individuell ansteuerbare Düsen. Jede der Düsen ist beispielsweise dazu konfiguriert, die Größe und/oder Frequenz der Tropfen, die von der jeweiligen Düse ausgestoßen werden, in Abhängigkeit von Steuerungsdaten des Steuerungsgerätes zu steuern.

Jetten bezieht sich auf eine berührungslose Dosierung, bei welcher eine abdosierte, zusammenhängende Flüssigkeitsmenge frei, d.h. vollständig von der Dosieröffnung einer Dosiervorrichtung, etwa einer Düse eines Druckkopfs, losgelöst, auf eine für sie vorgesehen Zielposition zufliegt. Hierbei erfolgt ein wiederholtes, rückstandsfreies Ablösen definierten Flüssigkeitsmengen von der Dosieröffnung. Die Dosiervorrichtung bewegt sich relativ zu der zu bedruckenden Oberfläche (oder umgekehrt) und gibt im geeigneten Zeitpunkt eine Flüssigkeitsmenge ab, deren definierter Bewegungsimpuls im freien Flug zur vorgesehenen Zielposition führt. Eine Düse einer entsprechenden Dosiervorrichtung umfasst beispielsweise ein druckbeaufschlagte Kugelsitzventil, dessen Kugelverschluss durch pneumatische, elektromagnetische, elektropneumatische oder piezoelektrische Aktoren betätigt wird.

Die flüssige Lösung zum Aufdrucken der Isolierschutzschicht umfasst beispielsweise ein oder mehr der folgenden Stoffe: Ein Harz, beispielsweise ein Polymerharz, einen Ester, beispielsweise einen Acrylsäureester, und/oder ein Acrylat, beispielsweise cyclisches Trimethylolpropanformalacrylat. Ferner kann die flüssige Lösung beispielsweise Pigmente und/oder weitere Zusätze umfassen. Nach Ausführungsformen ist die Lösung insbesondere polyimidfrei.

Nach Ausführungsformen ist der flexible Abschnitt flexibler als die starren Abschnitte der starr-flexiblen Leiterplatte. Die höhere Flexibilität des flexiblen Abschnitts gegenüber dem starren Abschnitt wird beispielsweise durch die Reduktion der Materialstärke bzw. Dicke der starr-flexiblen Leiterplatte im Bereich des flexiblen Abschnitts erzielt. Ferner umfasst die Zwischenschicht beispielsweise ein flexibles dielektrisches Trägermaterial. Dabei kann sich die Zwischenschicht beispielsweise durch die flexiblen und starren Abschnitte der starr-flexiblen Leiterplatte erstreckt. Beispielsweise werden einseitig oder beidseitig Leiterbahnen auf die Trägerschicht aufgebracht. Beispielsweise wird das Trägermaterial ein oder beidseitig mit einer Folie eines leitfähigen Materials, etwa einer Kupferfolie, beschichtet. Dies kann kleberlos oder mittels eines Klebers, etwa eines Acrylklebers oder eines Epoxidklebers, erfolgen.

Das entsprechende flexible Trägermaterial umfasst beispielsweise Polyimid. Das entsprechende flexible Trägermaterial umfasst beispielsweise Polyacrylat. Beispielsweise umfasst das flexible Material alternative oder zusätzlich Polyurethan, thermoplastisches Polyurethan und/oder ein Flüssigkristallpolymer. Somit können Eigenschaften wie Flexibilität, Elastizität, Formbarkeit und Biegeschlaffheit im Bereich der flexiblen Abschnitte erhöht werden, sodass eine Leiterplatte als Schaltungsträger verwirklicht werden, welche abschnittsweise flexibel bewegbar ist.

Polyimid kann beispielsweise in Form eines flexiblen Polyimidfolien oder Polyimidschicht zum Bereitstellen des einrollbaren Substrats verwendet werden. Ferner kann beispielsweise ein Flüssigkristallpolymer (Liquid Crystal Polymer), etwa ein thermoplastische Flüssigkristallpolymer zum Bereitstellen des einrollbaren Substrats verwendet werden. Thermoplastisches Polyurethan wird beispielsweise aus Diolen und Isocyanaten ohne Einsatz von Weichmachern hergestellt und kann beispielsweise elastische Eigenschaften aufweisen. Das Multiblock Co-Polymer besteht aus harten und weichen Segmenten, wodurch Eigenschaften wie Flexibilität, Biegeschlaffheit und/oder Dehnbarkeit realisiert werden können. Eine hohe Oberflächenenergie macht Polyurethan kratz- und verschleißfest. Ferner besitzt Polyurethan zusätzliche vorteilhafte Eigenschaften wie einen hohen Weiterreißwiderstand oder gute wärmeisolierende Eigenschaften.

Beispielsweise umfassen die weiteren Materialschichten ein oder mehrere starre Materialien, welche eine deutlich geringere Flexibilität, Biegeschlaffheit und/oder Dehnbarkeit aufweisen als das flexible Material der Zwischenschicht. Bei den starren Materialien handelt es sich beispielsweise um glasfaserverstärkte epoxidharzbasierte Materialien, etwa FR4-Materialien. FR4 bezeichnet eine Klasse von schwer entflammbaren und flammenhemmenden Verbundwerkstoffen bestehend aus Epoxidharz und Glasfasergewebe. Im Bereich der flexiblen Abschnitte werden diese starren Materialien im Zuge des Abtragens der weiteren Materialschichten zum Freilegen der Isolierschutzschicht entfernt.

Nach Ausführungsformen ist das räumlich begrenzte Segment identisch mit dem mindestens einen flexiblen Abschnitt.

Ausführungsformen können den Vorteil haben, dass die Isolierschutzschicht nur in den Segmenten, d.h. im Bereich aufgedruckt wird, welche dem flexiblen Abschnitt entspricht und mithin freigelegt wird. Somit kann beispielsweise eine Lösung, etwa eine Tinte, gespart werden und der Druckprozess beschleunigt werden, da weniger zu drucken ist.

Nach Ausführungsformen erstreckt sich das räumlich begrenzte Segment über den flexiblen Abschnitt hinaus lateral in den mindestens einen angrenzenden starren Abschnitt hinein.

Ausführungsformen können den Vorteil haben, dass sich die Isolierschutzschichten oder die an den flexiblen Abschnitt angrenzenden starren Abschnitte hineinerstrecken. Somit kann sichergestellt werden, dass die Isolierschutzschicht insbesondere im Bereich des Übergangs zwischen dem flexiblen und dem starren Abschnitt vorhanden ist. Es kann beispielsweise verhindert werden, dass im Zuge des Freilegens der Isolierschutzschicht versehentlich auch Bereiche von der Zwischenschicht und insbesondere der Leiterbahnen der Zwischenschicht freigelegt werden, welche von der Isolierschutzschicht nicht überdeckt sind.

Nach Ausführungsformen verbindet der mindestens eine flexible Abschnitt zwei starre Abschnitte miteinander. Ausführungsformen können den Vorteil haben, dass die so mechanisch über den flexiblen Abschnitt miteinander verbundenen starren Abschnitten infolge der erhöhten Flexibilität des flexiblen Abschnitts gegenüber den starren Abschnitten relative zueinander bewegbar, insbesondere verschwenkbar sind.

Nach Ausführungsformen erstreckt sich das räumlich begrenzte Segment über den flexiblen Abschnitt hinaus lateral in beide von dem flexiblen Abschnitt verbundenen starren Abschnitte hinein. Somit kann sichergestellt werden, dass die Isolierschutzschicht insbesondere im Bereich des Übergangs zwischen dem flexiblen und dem starren Abschnitt vorhanden ist. Es kann beispielsweise verhindert werden, dass im Zuge des Freilegens der Isolierschutzschicht versehentlich auch Bereiche von der Zwischenschicht und insbesondere der Leiterbahnen der Zwischenschicht freigelegt werden, welche von der Isolierschutzschicht nicht überdeckt sind

Nach Ausführungsformen umfasst die starr-flexiblen Leiterplatte eine Mehrzahl von flexiblen Anschnitten, welche jeweils an mindestens einen der starren Abschnitte angrenzen.

Ausführungsformen können den Vorteil haben, dass eine entsprechende starr-flexible Leiterplatte infolge der Mehrzahl von flexiblen Abschnitten vielfältige geometrische Formen annehmen kann. Insbesondere kann eine entsprechende starr-flexible Leiterplatte mehrschichtig gefaltet werden und/oder mehrfach gebogen werden.

Nach Ausführungsformen verbinden die flexiblen Anschnitte jeweils zwei starre Abschnitte miteinander.

Nach Ausführungsformen ist die polymerisierte Isolierschutzschicht flexibel. Ausführungsformen können den Vorteil haben, dass die polymerisierte Isolierschutzschicht die Flexibilität des flexiblen Abschnitts nicht beeinträchtigt. Nach Ausführungsformen weist die die polymerisierte Isolierschutzschicht dieselbe oder eine höhere Flexibilität auf verglichen mit der Zwischenschicht.

Nach Ausführungsformen weist die polymerisierte Isolierschutzschicht eine Schmelztemperatur Ts auf, welche über einer Presstemperatur T_{P} des Heißverpressens liegt. Unter der Schmelztemperatur Ts wird hier die Temperatur verstanden, bei welcher die im Zuge des Aushärtens gebildeten Vernetzungen zwischen den Polymerketten aufgebrochen werden, d.h. bei der die polymerisierte Isolierschutzschicht in einen flüssigen Aggregatzustand übergeht und eine Polymerschmelze bildet bzw. schmilzt. Die Schmelztemperatur Ts wird hier für einen Druck angegeben, der dem Druck beim Heißverspressen entspricht, d.h. die Schmelztemperatur Ts liegt bei dem Druck des Heißverpressens über der Presstemperatur T_{P} des Heißverpressens. Somit verflüssigt sich die polymerisierte Isolierschutzschicht im Ergebnis während des Heißverpressens nicht. Ausführungsformen können den Vorteil haben, dass verhindert werden kann, dass die Isolierschutzschicht im Zuge des Heißverpressens aufweicht und im Zuge des aufgebrachten Drucks ihre geometrische Form verliert, beispielsweise aus dem räumlich begrenzten Segment herausgedrückt wird.

Nach Ausführungsformen liegt die Schmelztemperatur Ts der polymerisierten Isolierschutzschicht 10°C oder mehr über der Presstemperatur Tp. Beispielsweise erfolgt das Heißverpressen bei Temperaturen von 160°C bis 220°C, 165°C bis 210°C, 170°C bis 200°C, und/oder 175°C bis 190°C. Die vorangehende Angabe der Schmelztemperatur Ts ist für einen Druck angegeben, der dem Druck beim Heißverspressen entspricht. Beispielsweise erfolgt das Heißverpressen bei einem Druck von 5 bar bis 20 bar, 6 bar bis 18 bar, 7 bar bis 16 bar, 8 bar bis 14 bar und/oder 7 bar bis 12 bar. Beispielsweise erfolgt das Heißverpressen bei einer Temperatur von 180°C und einem Druck von 10 bar. Die Schmelztemperatur Ts der polymerisierten Isolierschutzschicht liegt bei 10 bar beispielsweise bei 190°C oder mehr.

Nach Ausführungsformen wird die Zwischenschicht mit einer Mehrzahl von weiteren Materialschichten kombiniert und zu einem Verbundkörpers heißverpresst.

Ausführungsformen können den Vorteil haben, dass die Zwischenschicht beispielsweise beidseitig mit weiteren Materialschichten kombiniert werden und/oder dass die weiteren Materialschichten ein oder mehrere Leiterschichten umfassen können. Entsprechende Leiterschichten umfassen jeweils ein oder mehrere Leiterbahnen. Somit kann beispielsweise durch die weiteren Materialschichten im Bereich der starren Abschnitte ein mehrschichtiger Aufbau realisiert werden, welcher neben der Zwischenschicht weitere übereinander angeordnete Leiterschichten umfasst. Beispielsweise können die entsprechenden weiteren Leiterschichten sowohl oberhalb als auch unterhalb der Zwischenschicht angeordnet sein. Beispielsweise wird die Flexibilität der starren Abschnitte infolge der weiteren Materialschichten, welche beispielsweise eine geringere Flexibilität als die Zwischenschicht aufweisen, reduziert.

Nach Ausführungsformen ist die Zwischenschicht beidseitig mit jeweils ein oder mehreren Leiterbahnen versehen. Ausführungsformen können den Vorteil haben, dass die Anzahl der leiterbahnen der Zwischenschicht erhöht werden kann.

Nach Ausführungsformen handelt es sich bei der Zwischenschicht um eine Mittelschicht der herzustellenden starr-flexiblen Leiterplatte.

Eine entsprechende Mittelschicht ist in einem mittleren Bereich des Verbundkörpers angeordnet, d.h. es sind sowohl oberhalb als auch unterhalb der entsprechenden Mittelschicht weitere Materialschichten angeordnet. Ferner kann eine Ausgestaltung der Zwischenschicht als Mittelschicht beispielsweise einen symmetrischen Aufbau des Verbundkörpers ermöglichen, welcher den Vorteil hat, dass das Verhalten der starr-flexiblen Leiterplatte bei einem Biegen in eine Richtung, in welche die Oberseite der Zwischenschicht gewandt ist, identisch ist zu einem Biegen in einer Richtung, in welche die Unterseite der Zwischenschicht zugewandt ist.

Nach Ausführungsformen wird auf die Mitteschicht beidseitig jeweils eine Isolierschutzschicht mittels Inkjetdruckverfahren innerhalb eines räumlich begrenzten Segments, dessen Fläche kleiner als die Fläche der Mitteschicht ist, aufgedruckt. Die aufgedruckten Mitteschichten überdecken die Leiterbahnen der jeweiligen Seite der Zwischenschicht zumindest innerhalb des mindestens einen flexiblen Abschnitts. Die beidseitigen Isolierschutzschichten werden jeweils polymerisiert. Die Mittelschicht mit den beidseitigen Isolierschutzschichten wird beidseitig mit ein oder mehreren der weiteren Materialschichten kombiniert und zu einem Verbundkörpers heißverpresst. Beidseitig werden die Isolierschutzschichten innerhalb des mindestens einen flexiblen Abschnitts freigelegt.

Das Aufdrucken der Isolierschutzschichten sowie deren Freilegen erfolgt mithin von beiden Seiten der Mittelschicht bzw. des aus dem Heißverpressen resultierenden Verbundkörpers von beiden Seiten, aufseiten der Oberseite sowie aufseiten der Unterseite. Die entsprechende Mittelschicht ist dabei beispielsweise beidseitig mit einer oder mehreren Leiterbahnen versehen.

Nach Ausführungsformen wird die Mittelschicht beidseitig jeweils mit einer identischen Anzahl an weiteren Materialschichten kombiniert und der resultierende Verbundkörper weist einen symmetrischen Aufbau bezogen auf die Mittelschicht auf.

Ausführungsformen können den Vorteil haben, dass ein symmetrischer Aufbau der starr-flexiblen Leiterplatte relativ zu der Mittelschicht realisiert werden kann.

Nach Ausführungsformen wird die Mittelschicht beidseitig jeweils mit unterschiedlichen Anzahlen an weiteren Materialschichten kombiniert und der resultierende Verbundkörper weist einen asymmetrischen Aufbau bezogen auf die Mittelschicht auf.

Ausführungsformen können den Vorteil haben, dass ein asymmetrischer Aufbau der starr-flexiblen Leiterplatte relativ zu der Mittelschicht realisiert werden kann.

Nach Ausführungsformen handelt es sich bei ein oder mehrere der weiteren Materialschichten um Leiterschichten, welche mit ein oder mehreren weiteren Leiterbahnen versehen sind.

Ausführungsformen können den Vorteil haben, dass Leiterbahnen im Bereich der starren Abschnitte auf mehreren Ebenen übereinander angeordnet werden können. Entsprechende Leiterbahnen auf unterschiedlichen Ebenen können beispielsweise leitend miteinander verbunden sein, etwa über Vias, wodurch eine komplexe elektrisch leitfähige Kontaktierung auf engem Raum realisiert werden kann.

Nach Ausführungsformen kann es sich bei der starr-flexiblen Leiterplatte beispielsweise um eine starr-flexiblen Leiterplatte ("rigid flex printed board") handeln, wie sie in dem Standard IPC-6013 "Qualification and Performance Specification for Flexible/Rigid-Flexible Printed Boards" der IPC beschrieben wird. Beispielsweise kann es sich um eine starr-flexible Leiterplatte des Typs 1, 2, 3 oder 4 gemäß IPC-6013 handeln. Beispielsweise weist die starr-flexiblen Leiterplatte eine zumindest abschnittsweise mehrschichtige ("multilayer") Struktur auf, die zumindest einen starren ("rigid") Abschnitt sowie zumindest einen flexiblen ("flexible") Abschnitt umfasst.

Ausführungsformen können den Vorteil haben, dass der flexible Abschnitt ein Biegen der starr-flexiblen Leiterplatte ermöglicht.

Ausführungsformen können den Vorteil haben, dass die starren Abschnitte ein Verbiegen der Leiterplatte in diesem Bereich verhindern. Zudem können die starren Abschnitte beispielsweise zum Anordnen von elektronischen Bauteilen verwendet werden. Ferner können die starren Abschnitte für eine komplexe elektrisch leitfähige Kontaktierung auf verschiedenen Ebenen verwendet werden. Der dafür notwendige mehrschichtige Aufbau kann beispielsweise die Flexibilität in Bereichen der starren Abschnitte reduzieren.

Nach Ausführungsformen handelt es sich bei dem Inkjetdruckverfahren um ein 2D-Jetdruckverfahren. Eine Schichtdicke der gedruckten Isolierschutzschicht ist konstant, während eine räumliche Verteilung auf der Zwischenschicht innerhalb des räumlich begrenzten Segments variiert.

Ausführungsformen können den Vorteil haben, dass die Isolierschutzschicht im Bereich des räumlich begrenzten Segments bzw. des flexiblen Abschnitts nicht flächig durchgängig ausgestaltet sein muss. Beispielsweise wird die Isolierschutzschicht in ihrer räumlichen Verteilung variiert. Beispielsweise wird die Isolierschicht gemäß einem 2D-Muster auf der Zwischenschicht verteilt gedruckt. Beispielsweise werden gezielt nur die ein oder mehreren Leiterbahnen im Bereich des räumlich begrenzten Segments von der Isolierschutzschicht abgedeckt werden. In diesem Fall entspricht das 2D-Muster der Verteilung der ein oder mehreren Leiterbahnen mit denen die Zwischenschicht versehen ist.

Nach Ausführungsformen handelt es sich bei dem Inkjetdruckverfahren um ein 3D-Druckverfahren. Die Schichtdicke der gedruckten Isolierschutzschicht innerhalb des räumlich begrenzten Segments variiert.

Ausführungsformen können den Vorteil haben, dass durch ein entsprechendes 3D-Druckverfahren die Schichtdicke der gedruckten Isolierschutzschicht innerhalb des räumlich begrenzten Segments variiert werden kann. Somit kann beispielsweise der isolierende Effekt der Isolierschutzschicht räumlich variieren. Beispielsweise können die Leiterbahnen zu einer Variation der Schichtdicke der Zwischenschicht führen, welche durch eine entsprechend gegenläufig ausgestaltete Schichtdicke der gedruckten Isolierschutzschicht kompensiert werden.

Herstellungsvorrichtung zum Herstellen einer starr-flexiblen Leiterplatte, welche ein oder mehrere starre Abschnitte sowie mindestens einen flexiblen Abschnitt umfasst, wobei der mindestens eine flexible Abschnitt an mindestens einen der starren Abschnitte angrenzt. Die Vorrichtung umfasst eine Druckvorrichtung zum Aufdrucken einer Isolierschutzschicht mittels Inkjetdruckverfahren auf eine Zwischenschicht innerhalb eines räumlich begrenzten Segments, dessen Fläche kleiner als eine Fläche der Zwischenschicht ist, wobei die Zwischenschicht mit ein oder mehreren Leiterbahnen versehenen ist, wobei die aufgedruckte Isolierschutzschicht die Leiterbahnen zumindest innerhalb des mindestens einen flexiblen Abschnitts überdeckt, eine Polymerisierungsvorrichtung zum Polymerisieren der aufgedruckte Isolierschutzschicht, eine Heißverpressvorrichtung zum eines Verbundkörpers durch Heißverpressen der Kombination aus der Zwischenschicht und ein oder mehreren weiteren Materialschichten und eine Freilegevorrichtung zum Freilegen der Isolierschutzschicht innerhalb des mindestens einen flexiblen Abschnitts.

Ferner umfasst die Herstellungsvorrichtung beispielsweise ein Steuerungsgerät zum Steuern der Herstellungsvorrichtung. Das Steuerungsgerät umfasst beispielsweise einen Prozessor und einen Speicher mit Programminstruktionen. Ein Ausführen der Programminstruktionen durch den Prozessor veranlasst das Steuerungsgerät beispielsweise dazu die Druckvorrichtung, Polymerisierungsvorrichtung, Heißverpressvorrichtung und/oder Freilegevorrichtung zum Ausführen eines Verfahrens zum Herstellen einer starr-flexiblen Leiterplatte nach einer der vorangehende beschriebene Ausführungsformen auszuführen.

Ausführungsformen umfassen ferner eine starr-flexible Leiterplatte, welche ein oder mehrere starre Abschnitte sowie mindestens einen flexiblen Abschnitt umfasst. Der mindestens eine flexible Abschnitt grenzt an mindestens einen der starren Abschnitte an. Die starr-flexible Leiterplatte umfasst eine mit ein oder mehreren Leiterbahnen versehene Zwischenschicht, welche in den ein oder mehreren starren Abschnitten mit ein oder mehreren weiteren Materialschichten zu einem Verbundkörper heißverpresst ist. Die Zwischenschicht ist in dem mindestens einen flexiblen Abschnitt mittels Inkjetdruckverfahren mit einer freiliegenden Isolierschutzschicht bedruckt, welche Leiterbahnen der Zwischenschicht überdeckt.

Nach Ausführungsformen erstreckt sich die aufgedruckte Isolierschutzschicht auf der Zwischenschicht über den flexiblen Abschnitt hinaus lateral in den mindestens einen angrenzenden starren Abschnitt hinein. Innerhalb des starren Abschnitts ist die Isolierschutzschicht nicht freilegend, vielmehr erstreckt sie sich beispielsweise zwischen der Zwischenschicht und einer der weiteren Materialschichten des starren Abschnitts.

Im Weiteren werden Ausführungsformen der Erfindung mit Bezugnahme auf die Figuren näher erläutert. Es zeigen:
- Figur 1: ein schematisches Flussdiagramm eines exemplarischen Verfahrens zum Herstellen einer starr-flexiblen Leiterplatte,
- Figur 2: schematische Zwischenstufen des exemplarischen Herstellungsverfahrens aus Figur 1,
- Figur 3: ein schematisches Blockdiagramm einer starr-flexiblen Leiterplatte,
- Figur 4: ein schematisches Blockdiagramm einer Draufsicht auf eine exemplarische starr-flexible Leiterplatte,
- Figur 5: schematische Blockdiagramme einer gebogenen flexiblen Leiterplatte,
- Figur 6: ein schematisches Blockdiagramm einer exemplarischen Druckvorrichtung zum Aufdrucken einer Isolierschutzschicht, und
- Figur 7: ein schematisches Blockdiagramm einer exemplarischen Druckvorrichtung zum parallelisierten Aufdrucken einer Isolierschutzschicht, und
- Figur 8: ein schematisches Blockdiagramm einer exemplarischen Herstellungsvorrichtung zum Herstellen einer starr-flexiblen Leiterplatte.

Elemente der nachfolgenden Ausführungsformen, die einander entsprechen, werden mit denselben Bezugszeichen gekennzeichnet.

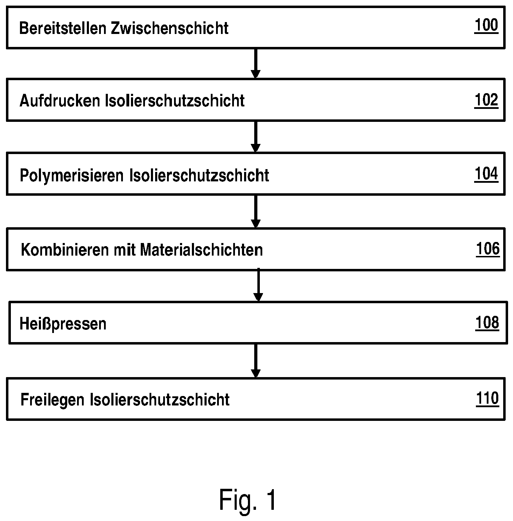

Figur 1 veranschaulicht ein exemplarisches Verfahren zum Herstellen einer starr-flexiblen Leiterplatte. In Block 100 wird eine Zwischenschicht bereitgestellt, welche mit einer oder mehreren Leiterbahnen versehen ist. Beispielsweise besteht die Zwischenschicht aus Polyimid. Die Zwischenschicht ist beispielsweise ein- oder beidseitig mit Leiterbahnen versehen, d.h. Ober- und Unterseite. Die Leiterbahnen bestehen beispielsweise aus Kupfer. In Block 102 wird auf die bereitgestellte Zwischenschicht eine Isolierschutzschicht innerhalb eines räumlich begrenzten Segments mittels Inkjetdruckverfahrens aufgedruckt. Die Fläche des räumlich begrenzten Segments ist kleiner als die Fläche der Zwischenschicht. Beispielsweise erstreckt sich die Zwischenschicht durch die gesamte herzustellende starr-flexible Leiterplatte hindurch. Die aufgedruckte Isolierschutzschicht überdeckt die Leiterbahnen der Zwischenschicht zumindest innerhalb Abschnitte der herzustellenden starr-flexible Leiterplatte.

Die herzustellende starr-flexible Leiterplatte umfasst beispielsweise ein oder mehrere flexible Abschnitte sowie ein oder mehrere starre Abschnitte. Der mindestens eine flexible Abschnitt grenzt an mindestens einen der starren Abschnitte an. Beispielsweise ist jeder flexible Abschnitt jeweils zwischen zwei starren Abschnitten angeordnet und verbindet diese sowohl mechanisch als auch einander.

Die Isolierschutzschicht wird beispielsweise einseitig auf die Zwischenschicht aufgedruckt, insbesondere im Falle einer einseitig mit Leiterbahnen versehenen Zwischenschicht. Beispielsweise werden beidseitig Isolierschutzschichten auf die Zwischenschicht aufgedruckt und es erfolgt beispielsweise im Falle einer beidseitig mit Leiterbahnen versehenen Zwischenschicht.

In Block 104 werden die aufgedruckten Isolierschutzschichten polymerisiert. Ein entsprechendes Polymerisieren der Isolierschutzschichten erfolgt beispielsweise unter Wärmeeinwirkung. Beispielsweise wird die Zwischenschicht der aufgedruckten Isolierschutzschicht in einen Ofen eingebracht, in welchem die Isolierschutzschicht aushärtet. Beispielsweise erfolgt das Polymerisieren unter Verwendung von UV-Licht, mit welchem die Isolierschutzschicht belichtet wird. Im Falle einer beidseitig aufgedruckten Isolierschutzschicht wird beispielsweise zunächst eine Seite der Zwischenschicht mit der Isolierschutzschicht bedruckt und die aufgedruckte Isolierschutzschicht polymerisiert. Nach der Polymerisierung der zuerst aufgedruckten Isolierschutzschicht wird beispielsweise auf der anderen Seite der Zwischenschicht Licht aufgedruckt und polymerisiert. In Block 106 wird die Zwischenschicht mit mehreren weiteren Materialschichten kombiniert. Die Zwischenschicht sowie die entsprechenden weiteren Materialschichten liegen beispielsweise in Form von Materialbögen vor, welche übereinander angeordnet werden. Beispielsweise werden weitere Materialschichten oberhalb und unterhalb der Zwischenschicht angeordnet, sodass es sich bei der Zwischenschicht um einen Verbundkörper handelt. In Block 108 wird die Kombination aus Zwischenschicht und weiteren Materialschichten zu einem Verbundkörper heißverpresst. Hierzu wird sowohl Druck auf den Stapel von Materialschichten inklusive der Zwischenschicht als auch Hitze aufgebracht. In Block 110 werden die aufgedruckten und polymerisierten Isolierschutzschichten innerhalb der flexiblen Abschnitte der starr-flexiblen Leiterplatte freigelegt. Hierzu werden die weiteren Materialschichten in dem entsprechenden Bereich abgetragen. Das Abtragen kann durch ein entsprechendes materialabtragendes Verfahren, wie etwa Fräsen, erfolgen. Durch das Abtragen der weiteren Materialschichten im Bereich der flexiblen Abschnitte wird die Materialstärke bzw. Dicke der starr-flexiblen Leiterplatte im Bereich der flexiblen Abschnitte reduziert, wodurch deren Flexibilität erhöht bzw. erzielt wird. Im Falle beidseitig auf die Zwischenschicht aufgedruckter Isolierschutzschichten erfolgt das Freilegen der entsprechenden Isolierschutzschichten beidseitig.

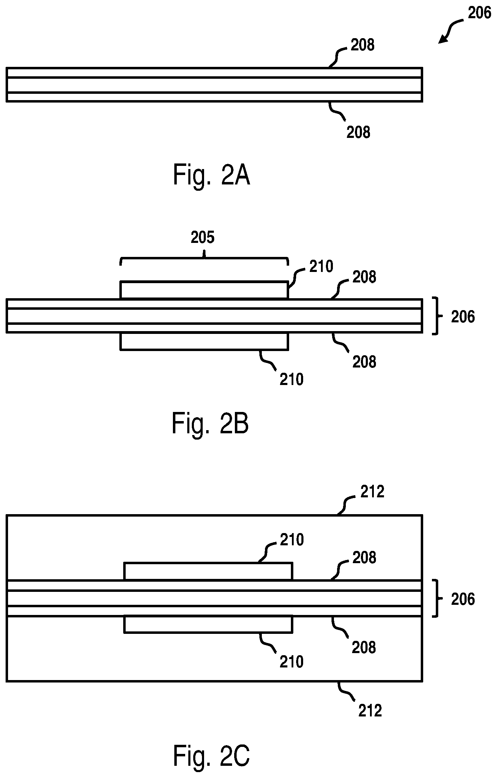

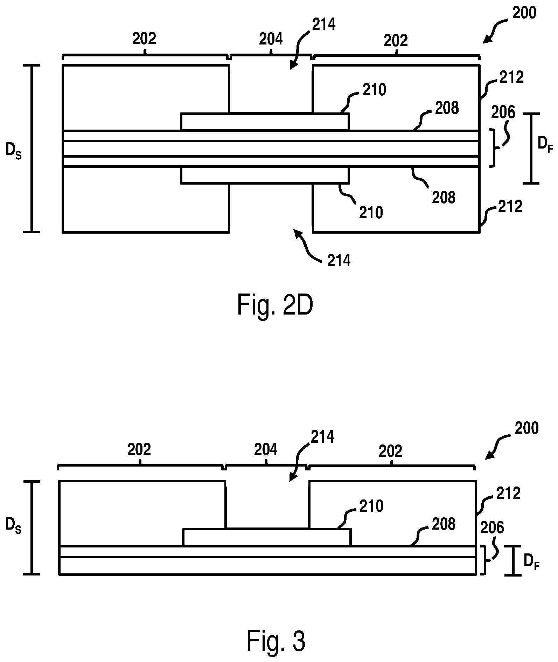

In der Figur 2 sind verschiedene Zwischenschritte des Verfahrens zum Herstellen der starr-flexiblen Leiterplatte aus Figur 2 gezeigt. Figur 2A zeigt die bereitgestellte Zwischenschicht 206, welche beispielsweise beidseitig, d.h. auf einer Oberseite und einer Unterseite, mit Leiterbahnen 208 versehen ist. Auf die mit Leiterbahnen versehene Zwischenschicht wird, wie in Figur 2B gezeigt, eine Isolierschutzschicht im Bereich eines räumlich begrenzten Segments mittels eines Inkjetdruckverfahrens aufgedruckt. Die Fläche des entsprechend räumlich begrenzten Segments ist kleiner als die Fläche der Zwischenschicht 206. Die Isolierschutzschicht 210 überdeckt dabei die Leiterbahnen 208 zumindest innerhalb des mindestens einen flexiblen Abschnitts 204 in der herzustellenden Leiterplatte 200. Das räumliche begrenzte Segment 205 kann identisch sein zum flexiblen Abschnitt 206 oder sich lateral weiter erstrecken als der flexible Abschnitt 204. Beispielsweise wird die Isolierschutzschicht einseitig oder beidseitig auf die Zwischenschicht 206 aufgedruckt.

Nach einem Polymerisieren der aufgedruckten Isolierschutzschicht 210 wird die Zwischenschicht 206, wie Figur 2C gezeigt, mit weiteren Materialschichten 212, welche beispielsweise oberhalb und/oder unterhalb der Kernschutzschicht angeordnet werden, kombiniert und zu einem Verbundkörper heißverpresst. Die entsprechenden weiteren Materialschichten 212 können beispielsweise ein oder mehrere Leiterschichten mit weiteren Leiterbahnen (nicht gezeigt) umfassen.

Schließlich werden die Isolierschutzschichten 210, wie in Figur 2D gezeigt, innerhalb des flexiblen Abschnitts 204 freigelegt. Hierzu werden Ausnehmungen 214 in die weiteren Materialschichten 212 eingebracht. Beispielsweise erfolgt das Freilegen mittels eines materialabtragenden Verfahrens, wie etwa Fräsen. Durch die Materialabtragung wird die Materialstärke bzw. Dicke D_{F} der starr-flexiblen Leiterplatte 200 im Bereich des flexiblen Abschnitts 204 gegenüber der Materialstärke bzw. Dicke Ds der starr-flexiblen Leiterplatte 200 im Bereich der starren Abschnitte 202 reduziert. Dies führt zu einer Erhöhung der Flexibilität bzw. ermöglicht die Flexibilität im Bereich des flexiblen Abschnitts 204. Zugleich werden die Leiterbahnen 208 der Zwischenschicht 206 im Bereich des flexiblen Abschnitts 204 durch die Isolierschutzschichten 210 effektiv gegen äußere Einflüsse geschützt. Bei den entsprechenden äußeren Einflüssen kann es sich beispielsweise um mechanische, chemische und/oder elektromagnetische Einflüsse handeln. Insbesondere im Fall von Kupfer, welches sich durch eine hohe elektrische Leitfähigkeit auszeichnet, kann das Kupfer die Isolierschutzschicht 210 effektiv gegen chemische Reaktionen infolge der hohen Reaktionsfähigkeit des Kupfers geschützt werden.

Bei der in Figur 2D gezeigten starr-flexiblen Leiterplatte 200 handelt es sich um eine starr-flexible Leiterplatte, bei welcher die Zwischenschicht 206 als Mittelschicht in einem mittleren Bereich bzw. auf einer mittleren Ebene der starr-flexiblen Leiterplatte 200 angeordnet ist. Die Schicht 206 ist beidseitig mit einer oder mehreren Leiterbahnen 208 versehen, welche im Bereich des flexiblen Abschnitts 204 beidseitig durch Isolierschutzschichten 210 vor äußeren Einflüssen geschützt sind. In dem gezeigten Beispiel erstrecken sich die Isolierschutzschichten 210 lateral über den flexiblen Abschnitt 204 hinaus in die starren Bereiche 202 hinein. Alternativerweise können sich die Isolierschutzschichten auch nur innerhalb des flexiblen Bereichs 204 erstrecken. Ferner ist die Zwischenschicht beidseitig mit weiteren Materialschichten 212 zu einem Verbundkörper heißverpresst. Das bedeutet, dass beidseitig weitere Materialschichten angeordnet sind. Die entsprechenden weiteren Materialschichten 212 können beispielsweise ein oder mehrere Leiterschichten umfassen, d.h. es können sich seitlich weitere Leiterbahnen auf unterschiedlichen Ebenen innerhalb der starren Abschnitte 202 parallel zur Ebene der Zwischenschicht 206 erstrecken. Diese entsprechenden weiteren Leiterbahnen können beispielsweise elektrisch leitend miteinander verbunden sein. Entsprechende elektrisch leitfähige Verbindungen können beispielsweise mittels Vias hergestellt werden. Beispielsweise können die weiteren Leiterbahnen mit den Leiterbahnen 208 der Zwischenschicht 206 leitend verbunden sein. Beispielsweise können entsprechende leitfähige Verbindungen mittels Vias hergestellt sein.

Figur 3 zeigt eine weitere Ausführungsform einer exemplarischen starr-flexiblen Leiterplatte 200, die im Gegensatz zu der in Figur 2D gezeigten starr-flexiblen Leiterplatte 200 nicht symmetrisch, d.h. asymmetrisch, zu der Zwischenschicht 206 ausgestaltet ist. Beispielsweise ist die Zwischenschicht 206 nur einseitig mit Leiterbahnen 208 versehen. Ferner wird beispielsweise nur einseitig auf die Zwischenschicht 206 eine Isolierschutzschicht aufgedruckt und es werden beispielsweise auch nur einseitig ein oder mehrere weitere Materialschichten 212 auf der Zwischenschicht angeordnet und zu einem Verbundkörper heißverpresst. In diesem Fall erfolgt beispielsweise auch nur einseitig ein Freilegen der entsprechenden Isolierschutzschicht 210 durch Einbringen einer Ausnehmung 212 in die weiteren Materialschichten 212.

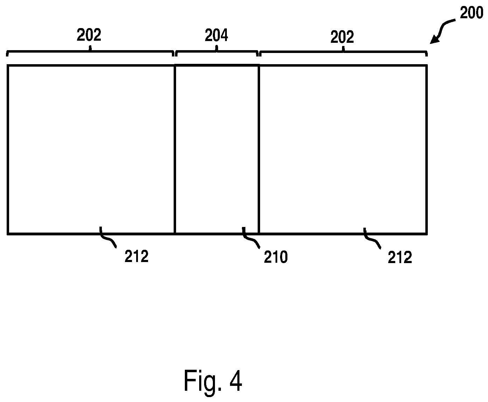

Figur 4 zeigt eine Draufsicht auf eine exemplarische starr-flexible Leiterplatte 200. Die exemplarische starr-flexible Leiterplatte 200 umfasst zwei starre Abschnitte 202, welche durch einen flexiblen Abschnitt 204 sowohl mechanisch als auch elektrisch leitfähig miteinander verbunden sind. Die elektrische leitfähige Verbindung wird beispielsweise durch ein oder mehrere Leiterbahnen, mit welchen die Zwischenschicht der starr-flexiblen Leiterplatte 200 versehen ist, hergestellt. Die Zwischenschicht erstreckt sich beispielsweise durch die gesamte starr-flexible Leiterplatte 200 hindurch, d.h. sowohl durch die beiden starren Abschnitte 202 als auch durch den flexiblen Abschnitt 204. Die Leiterbahnen der Zwischenschicht sind im Bereich des flexiblen Abschnitts 204 durch eine auf die Zwischenschicht aufgedruckte Isolierschutzschicht 210 gegen äußere Einflüsse geschützt. Im Bereich der starren Abschnitte 202 sind jeweils ein oder mehrere weitere Materialschichten auf der Zwischenschicht angeordnet und mit dieser heißverpresst. Die Isolierschutzschicht 210 im Bereich des flexiblen Abschnitts 204 ist wie in Figur 4 gezeigt freigelegt. Hierzu wird beispielsweise Material der weiteren Materialschichten 212 im Bereich des flexiblen Abschnitts mittels eines materialabtragenden Verfahrens abgetragen, beispielsweise mittels Fräsen.

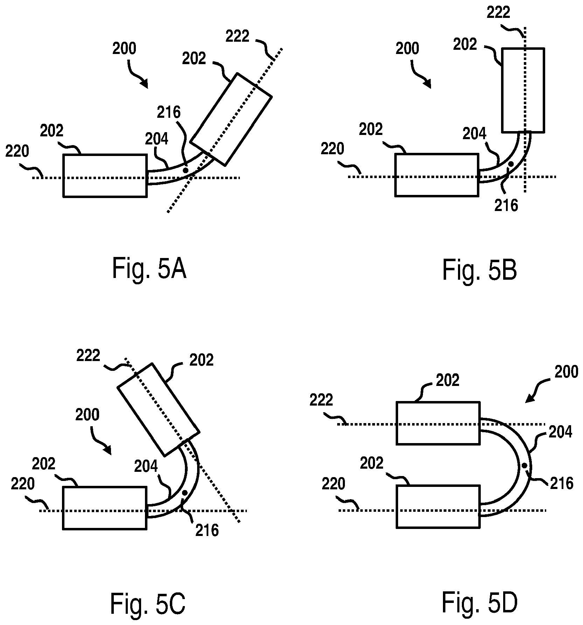

Figur 5 zeigt eine exemplarische starr-flexible Leiterplatte 200, wie sie beispielsweise auch in Figur 2D gezeigt ist. Die entsprechende starr-flexible Leiterplatte umfasst zwei starre Abschnitte 202, welche mittels eines flexiblen Abschnitts 204 miteinander verbunden sind. Die Flexibilität des flexiblen Abschnitts 204 ermöglicht beispielsweise ein Biegen der starr-flexible Leiterplatte 200 um eine Biegeachse 216 im flexiblen Abschnitt 204 hindurch. Beispielsweise erstreckt sich die Biegeachse 216 in einer Querrichtung der starr-flexiblen Leiterplatte 200. In den Figuren 5A bis 5D erstreckt sich die Biegeachse 216 senkrecht hinein. Durch ein Biegen der starr-flexiblen Leiterplatte 200 um die Biegeachse 216 kann beispielsweise einer der beiden starren Abschnitte aus einer ersten Erstreckungsebene 220 der beiden starr-flexiblen Abschnitte 202 heraus verschwenkt werden, sodass sich die Erstreckungsebene 222 das Verschwenken des starren Abschnitts 202 nicht mehr parallel zu der Erstreckungsebene 220 des anderen starren Abschnitts 202 erstreckt. Beispielsweise kann die Erstreckungsebene 220 im Zuge des Verschwenkens um einen spitzen Winkel, beispielsweise 45°, aus der Erstreckungsebene 220 verschwenkt. Diese Situation ist exemplarisch in Figur 5A dargestellt. In Figur 5B ist eine exemplarische Situation dargestellt, in der die Erstreckungsebene 222 des verschwenkten starren Abschnitts 202 um 90° aus der Erstreckungsebene 220 verschwenkt ist. In Figur 5C ist eine Situation dargestellt, in welcher die Erstreckungsebene 222 des verschwenkten starren Abschnitts 202 um einen stumpfen Winkel 235° aus der Erstreckungsebene 220 verschwenkt ist. In Figur 5D wird schließlich eine exemplarische Situation gezeigt, in welcher die Erstreckungsebene 222 infolge des Verschwenkens um 280° relativ zu der Erstreckungsebene 220 verschwenkt ist, sodass sich die beiden Erstreckungsebenen im Ergebnis wieder parallel zueinander erstrecken.

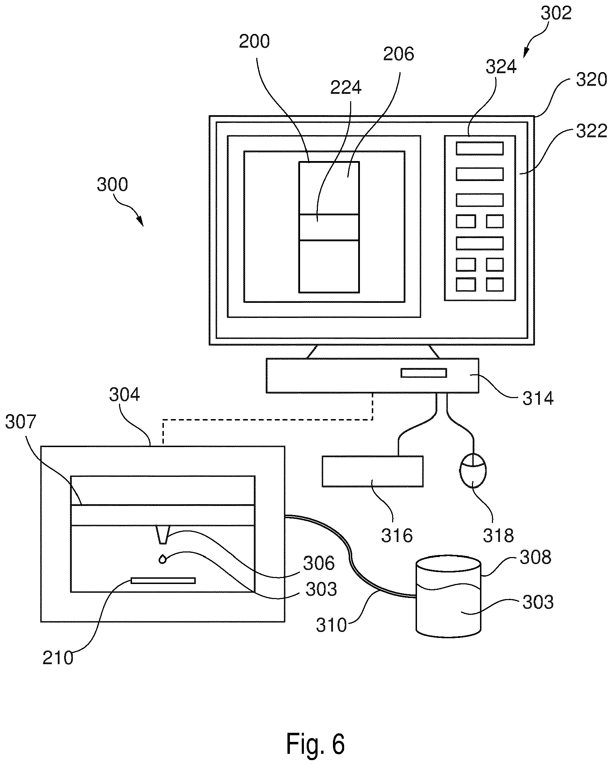

Figur 6 zeigt eine exemplarische Inkjetdruckvorrichtung 300 zum Aufdrucken einer Isolierschutzschicht in Form einer Lösung 303, beispielsweise einer Tinte, auf eine Zwischenschicht 206 einer Leiterplatte. Beispielsweise wird eine Inkjetdruckeinheit 304 bereitgestellt, welche einen Druckkopf 306 umfasst, welcher dazu konfiguriert ist, die Lösung 303 tröpfchenweise auf eine Oberfläche der Zwischenschicht 206 aufzudrucken. Zum Aufdrucken der Lösung 303 wird die Zwischenschicht 266 und/oder ein Materialbogen umfassend eine Mehrzahl von Abschnitten platziert, welche jeweils als Zwischenschicht für eine Leiterplatte dienen. Die Inkjetdruckeinheit 304 ist mittels einer Leitung 310 beispielsweise fluidisch mit einem Behältnis 308 verbunden, in welchem sich eine Lösung 303 befindet, d.h. eine Lösung mit einem Stoffgemisch für die Isolierschutzschicht. Es können beispielsweise ein oder mehrere Druckköpfe 306 vorgesehen sein, welche durch eine Bewegungseinheit 307 in zwei oder drei Raumrichtungen bewegbar sind. Die Druckköpfe 306 können beispielsweise jeweils einen oder mehrere individuell ansteuerbare Düsen umfassen. Jede der Düsen kann beispielsweise dazu konfiguriert sein, die Größe und/oder Frequenz der Tropfen, die von der jeweiligen Düse ausgestoßen werden, in Abhängigkeit von Steuerungsbefehlen eines Steuerungsgeräts 302 zu steuern. Eine Mehrzahl individuell ansteuer- und bewegbarer Düsen 306 ermöglicht beispielsweise ein paralleles Aufdrucken von isolierschutzschichten auf eine Mehrzahl von Zwischenschichten, welche beispielsweise in Form eines Materialbogens bereitgestellt werden. Ein entsprechender Materialbogen aus einem flexiblen Material zum Bereitstellen der Zwischenschichten umfasst beispielsweise eine Mehrzahl von Abschnitten, welche später jeweils eine Zwischenschicht einer Leiterplatte bilden.

Bei dem Steuerungsgerät 302 kann es sich beispielsweise um ein Computersystem handeln. Das entsprechende Computersystem kann Hardware 314 umfassen mit ein oder mehreren Prozessoren sowie einem Speicher, in welchem Programminstruktionen gespeichert sind zur Steuerung des Computersystems 302 sowie der Inkjetdruckeinheit 304. Zum Empfang von Eingaben kann das Steuerungsgerät 302 Eingabevorrichtungen, wie etwa eine Tastatur 316 und/oder eine Maus 318, umfassen. Ferner kann das Steuerungsgerät 302 beispielsweise eine Anzeigevorrichtung 320, wie etwa einen Bildschirm, umfassen, auf welchem eine grafische Benutzeroberfläche bzw. GUI ("Graphical User Interface") angezeigt wird. Die entsprechende grafische Benutzeroberfläche 322 kann beispielsweise eine 2D- oder 3D-Vorlage für die herzustellende Leiterplatte 200 bereitstellen. In der entsprechenden 2D- oder 3D-Vorlage für die herzustellende Leiterplatte 200 wird beispielsweise die mit ein oder mehreren Leiterbahnen 208 versehene Zwischenschicht 206 definiert sowie ein räumlich begrenztes Segment 224 der Zwischenschicht 206, innerhalb dessen die Isolierschutzschicht aufzudrucken ist. Die Isolierschutzschicht kann innerhalb des räumlich begrenztes Segment 224 beispielsweise als durchgängige Schicht mit einer konstanten Schichtdicke aufgedruckt werden. Beispielsweise kann die Isolierschutzschicht im Zuge eines 2D-Druckverfahrens mit einer konstanten Schichtdicke aufgedruckt werden, während zugleich eine räumliche Verteilung, d.h. eine 2D-Verteilung, auf der Zwischenschicht 206 innerhalb des räumlich begrenzten Segments 224 variiert wird. Beispielsweise kann die Isolierschutzschicht im Zuge eines 3D-Druckverfahrens aufgedruckt werde, bei welchem nicht nur die zweidimensionale räumliche Verteilung, sondern auch die Schichtdicke der aufgedruckten Isolierschutzschicht innerhalb des räumlich begrenzten Segments 224 variiert wird.

Mittels der entsprechenden Steuerungselemente 324 kann ein Nutzer unter Verwendung der Eingabevorrichtungen 316, 318 beispielsweise ein vordefiniertes Verteilungsschema für die Isolierschutzschicht auf der Zwischenschicht 206 auswählen, Anpassungen an einem vordefinierten Verteilungsschemas vornehmen und/oder selbst ein entsprechendes Verteilungsschema erstellen. Bei dem entsprechenden Verteilungsschema kann es sich beispielsweise um ein 2D-Verteilungsschema oder um ein 3D-Verteilungs bzw. Strukturschema handeln.

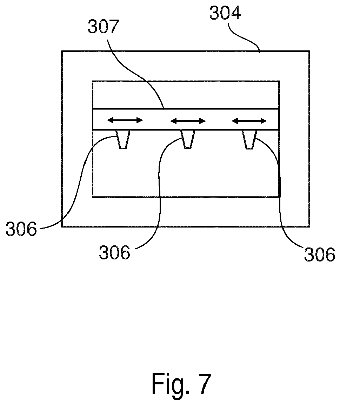

Figur 7 zeigt schließlich eine exemplarische Ausführungsform einer Inkjetdruckeinheit 304 der Vorrichtung aus Figur 6 mit einer Mehrzahl von Druckköpfen 306 zum parallelen Aufdrucken von Isolierschutzschichten auf Zwischenebenen für eine Mehrzahl von Leiterplatten. Die Bewegungseinheit 307 kann beispielsweise dazu ausgelegt sein, dass die individuellen Druckköpfe 306 unabhängig voneinander in 2D und/oder 3D verfahren und angesteuert werden können.

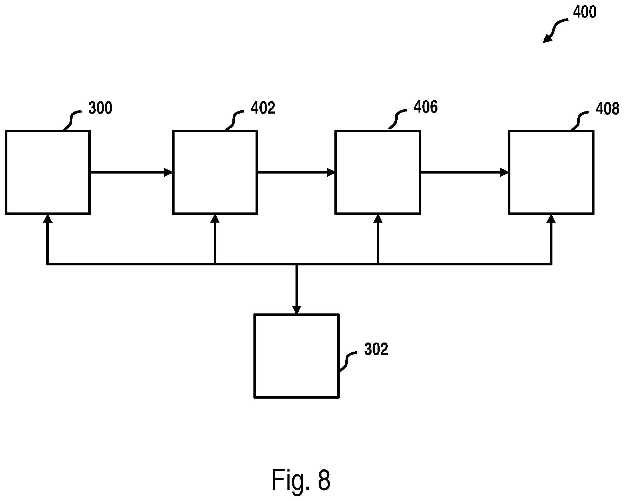

Figur 8 zeigt eine Herstellungsvorrichtung 400 zum Herstellen einer starr-flexiblen Leiterplatte. Die Herstellungsvorrichtung 400 umfasst beispielsweise eine Druckvorrichtung 300 mit einer Inkjetdruckereinheit, wie in Figur 6 gezeigt. Ferner umfasst die Herstellungsvorrichtung 400 beispielsweise eine Polymerisierungsvorrichtung 402, eine Heißverpressvorrichtung 406 und eine Freilegevorrichtung 408. Gesteuert wird die Herstellungsvorrichtung 400 beispielsweise mit einem Steuerungsgerät 302, wie es wie in Figur 6 gezeigt ist. Das entsprechende Steuerungsgerät 302 ist zusätzlich zum Steuern einer Inkjetdruckereinheit der Druckvorrichtung 300 beispielsweise zum Steuern der Polymerisierungsvorrichtung 402, Heißverpressvorrichtung 406 und Freilegevorrichtung 408 konfiguriert.

Die Druckvorrichtung 300 ist, wie in Figur 3 beschrieben, zum Aufdrucken einer Isolierschutzschicht mittels Inkjetdruckverfahren auf eine Zwischenschicht einer herzustellenden starr-flexiblen Leiterplatte innerhalb eines räumlich begrenzten Segments konfiguriert. Die Zwischenschicht ist mit ein oder mehreren Leiterbahnen versehenen und die aufgedruckte Isolierschutzschicht überdeckt die Leiterbahnen zumindest innerhalb des mindestens einen flexiblen Abschnitts. Die Polymerisierungsvorrichtung 402 ist zum Polymerisieren der aufgedruckte Isolierschutzschicht konfiguriert. Beispielsweise umfasst die Polymerisierungsvorrichtung 402 einen UV-Strahler und/oder ein Heizelement, wie einen Ofen, zum Beachlagen der Isolierschutzschicht mit UV-Licht und/oder Wärme zum Polymerisieren der aufgedruckten Isolierschutzschicht. Die Heißverpressvorrichtung 406 ist zum Bilden eines Verbundkörpers durch Heißverpressen einer Kombination aus der Zwischenschicht und ein oder mehreren weiteren Materialschichten konfiguriert. Die bedruckte Zwischenschicht wird mit ein oder mehreren weiteren Materialschichten kombiniert und unter Beaufschlagung mit Druck und Wärme zu einem Verbundkörper heißverpresst. Die Freilegevorrichtung 408 ist schließlich zum Freilegen der Isolierschutzschicht innerhalb des mindestens einen flexiblen Abschnitts konfiguriert. Beispielsweise erfolgt das freilegen mittels Fräsens. Zu diesem Zwecke umfasst die Freilegevorrichtung 408 beispielsweise ein oder mehrere Fräswerkzeuge, welche die weiteren Materialschichten innerhalb des mindestens einen flexiblen Abschnitts abtragen und so die Isolierschutzschicht freilegen.

### Bezugszeichenliste

- 200: Leiterplatte
- 202: starrer Abschnitt
- 204: flexibler Abschnitt
- 206: Zwischenschicht
- 208: Leiterbahn
- 210: Isolierschutzschicht
- 212: Materialschicht
- 214: Ausnehmung
- 216: Biegeachse
- 220: Erstreckungsebene
- 222: Erstreckungsebene
- 224: Segment
- 300: Druckvorrichtung
- 302: Steuerungsgerät
- 303: Lösung
- 304: Inkjetdruckereinheit
- 306: Druckkopf
- 307: Bewegungseinheit
- 308: Behältnis
- 310: fluidische Leitung
- 311: Lösung
- 314: Hardwarekomponente
- 316: Eingabevorrichtung
- 318: Eingabevorrichtung
- 320: Bildschirm
- 322: grafische Benutzeroberfläche
- 324: Steuerungselemente
- 400: Herstellungsvorrichtung
- 402: Polymerisierungsvorrichtung
- 406: Heißverpressvorrichtung
- 408: Freilegevorrichtung

## Patentansprüche

1. Verfahren zum Herstellen einer starr-flexiblen Leiterplatte (200), welche ein oder mehrere starre Abschnitte (202) sowie mindestens einen flexiblen Abschnitt (204) umfasst, wobei der mindestens eine flexible Abschnitt (204) an mindestens einen der starren Abschnitte (202) angrenzt, wobei das Verfahren umfasst:
• Bereitstellen einer mit ein oder mehreren Leiterbahnen (208) versehenen Zwischenschicht (206),
• Aufdrucken einer Isolierschutzschicht (210) mittels Inkjetdruckverfahren auf die Zwischenschicht (206) innerhalb eines räumlich begrenzten Segments (224), dessen Fläche kleiner als eine Fläche der Zwischenschicht (206) ist, wobei die aufgedruckte Isolierschutzschicht (210) die Leiterbahnen (208) zumindest innerhalb des mindestens einen flexiblen Abschnitts (204) überdeckt,
• Polymerisieren der aufgedruckte Isolierschutzschicht (210),
• Kombinieren der Zwischenschicht (206) mit ein oder mehreren Materialschichten (212),
• Erzeugen eines Verbundkörpers durch Heißverpressen der Kombination aus Zwischenschicht (206) und ein oder mehreren weiteren Materialschichten (212),
• Freilegen der Isolierschutzschicht (210) innerhalb des mindestens einen flexiblen Abschnitts (204).

2. Verfahren nach Anspruch 1, wobei das räumlich begrenzte Segment (224) identisch mit dem mindestens einen flexiblen Abschnitt (204) ist.

3. Verfahren nach Anspruch 1, wobei sich das räumlich begrenzte Segment (224) über den flexiblen Abschnitt (204) hinaus lateral in den mindestens einen angrenzenden starren Abschnitt (202) hineinerstreckt.

4. Verfahren nach einem der vorangehenden Ansprüche, wobei der mindestens eine flexible Abschnitt (204) zwei starre Abschnitte (202) miteinander verbindet.

5. Verfahren nach Anspruch 4, wobei sich das räumlich begrenzte Segment (224) über den flexiblen Abschnitt (204) hinaus lateral in beide von dem flexiblen Abschnitt (204) verbundenen starren Abschnitte (202) hineinerstreckt.

6. Verfahren nach einem der vorangehenden Ansprüche, wobei die starr-flexiblen Leiterplatte (200) eine Mehrzahl von flexiblen Anschnitten umfasst, welche jeweils an mindestens einen der starren Abschnitte (202) angrenzen.

7. Verfahren nach einem der vorangehenden Ansprüche, wobei die polymerisierte Isolierschutzschicht (210) flexibel ist.

8. Verfahren nach einem der vorangehen Ansprüche, wobei die polymerisierte Isolierschutzschicht (210) eine Schmelztemperatur Ts aufweist, welche über einer Presstemperatur des Heißverpressens liegt.

9. Verfahren nach Anspruch 8, wobei die Schmelztemperatur 10°C oder mehr über der Presstemperatur liegt.

10. Verfahren nach einem der vorangehenden Ansprüche, wobei die Zwischenschicht (206) mit einer Mehrzahl von weiteren Materialschichten kombiniert und zu einem Verbundkörpers heißverpresst wird.

11. Verfahren nach einem der vorangehenden Ansprüche, wobei die Zwischenschicht (206) beidseitig mit jeweils ein oder mehreren Leiterbahnen (208) versehen ist.

12. Verfahren Anspruch 11, wobei es sich bei der Zwischenschicht (206) um eine Mittelschicht handelt, auf welche beidseitig jeweils eine Isolierschutzschicht (210) mittels Inkjetdruckverfahren innerhalb eines räumlich begrenzten Segments (224), dessen Fläche kleiner als die Fläche der Mittelschicht (206) ist, aufgedruckt wird, wobei die aufgedruckten Isolierschutzschichten (210) die Leiterbahnen (208) der jeweiligen Seite der Mittelschicht (206) zumindest innerhalb des mindestens einen flexiblen Abschnitts (204) überdecken,
wobei die beidseitigen Isolierschutzschichten (210) jeweils polymerisiert werden,
wobei die Mittelschicht (206) mit den beidseitigen Isolierschutzschichten (210) beidseitig mit ein oder mehreren der weiteren Materialschichten (212) kombiniert und zu einem Verbundkörpers heißverpresst wird,
wobei beidseitig die Isolierschutzschichten (210) innerhalb des mindestens einen flexiblen Abschnitts (204) freigelegt werden.

13. Verfahren nach Anspruch 12, wobei die Mittelschicht (206) beidseitig jeweils mit einer identischen Anzahl an weiteren Materialschichten (212) kombiniert wird und der resultierende Verbundkörper einen symmetrischen Aufbau bezogen auf die Mittelschicht (206) aufweist.

14. Verfahren nach Anspruch 12, wobei die Mittelschicht (206) beidseitig jeweils mit unterschiedlichen Anzahlen an weiteren Materialschichten (212) kombiniert wird und der resultierende Verbundkörper einen asymmetrischen Aufbau bezogen auf die Mittelschicht (206) aufweist.

15. Verfahren nach einem der vorangehenden Ansprüche, wobei es sich bei ein oder mehrere der weiteren Materialschichten (212) um Leiterschichten handelt, welche mit ein oder mehreren weiteren Leiterbahnen versehen sind.

16. Verfahren nach einem der vorangehenden Ansprüche, wobei es sich bei dem Inkjetdruckverfahren um ein 2D-Druckverfahren handeln, wobei eine Schichtdicke der gedruckten Isolierschutzschicht (210) konstant ist, während eine räumliche Verteilung auf der Zwischenschicht (206) innerhalb des räumlich begrenzten Segments (224) variiert.

17. Verfahren nach einem der Ansprüche 1 bis 15, wobei es sich bei dem Inkjetdruckverfahren um ein 3D-Druckverfahren handeln, wobei die Schichtdicke der gedruckten Isolierschutzschicht (210) innerhalb des räumlich begrenzten Segments (224) variiert.

18. Vorrichtung (400) zum Herstellen einer starr-flexiblen Leiterplatte (200), welche ein oder mehrere starre Abschnitte (202) sowie mindestens einen flexiblen Abschnitt (204) umfasst, wobei der mindestens eine flexible Abschnitt (204) an mindestens einen der starren Abschnitte (202) angrenzt, wobei die Vorrichtung (400) umfasst:
• Druckvorrichtung (300) zum Aufdrucken einer Isolierschutzschicht (210) mittels Inkjetdruckverfahren auf eine Zwischenschicht (206) innerhalb eines räumlich begrenzten Segments (224), dessen Fläche kleiner als eine Fläche der Zwischenschicht (206) ist, wobei die Zwischenschicht (206) mit ein oder mehreren Leiterbahnen (208) versehenen ist, wobei die aufgedruckte Isolierschutzschicht (210) die Leiterbahnen (208) zumindest innerhalb des mindestens einen flexiblen Abschnitts (204) überdeckt,
• Polymerisierungsvorrichtung (402) zum Polymerisieren der aufgedruckte Isolierschutzschicht (210),
• Heißverpressvorrichtung (406) zum Bilden eines Verbundkörpers durch Heißverpressen einer Kombination aus der Zwischenschicht (206) und ein oder mehreren weiteren Materialschichten (212),
• Freilegevorrichtung (408) zum Freilegen der Isolierschutzschicht (210) innerhalb des mindestens einen flexiblen Abschnitts (204).

19. Starr-flexible Leiterplatte (200), welche ein oder mehrere starre Abschnitte (202) sowie mindestens einen flexiblen Abschnitt (204) umfasst, wobei der mindestens eine flexible Abschnitt (204) an mindestens einen der starren Abschnitte (202) angrenzt, wobei die starr-flexible Leiterplatte (200) eine mit ein oder mehreren Leiterbahnen (208) versehene Zwischenschicht (206) umfasst, welche in den ein oder mehreren starren Abschnitten (202) mit ein oder mehreren weiteren Materialschichten (212) zu einem Verbundkörper heißverpresst ist, wobei die Zwischenschicht (206) in dem mindestens einen flexible Abschnitt (204) mittels Inkjetdruckverfahren mit einer freiliegenden Isolierschutzschicht (210) bedruckt ist, welche Leiterbahnen (208) der Zwischenschicht (206) überdeckt.
